# EUROPÄISCHE PATENTANMELDUNG

(11) **EP 4 753 136 A1**
(43) Veröffentlichungstag der Anmeldung: **03.06.2026**
(21) Anmeldenummer: 25211596.9
(22) Anmeldetag: 28.10.2025
(51) Int. Cl.: H02M 7/00, H02M 7/483, H02M 7/5387, H03K 17/687, H10D 30/47, H10D 62/17, H10W 90/10, H10W 40/25, H10W 70/65, H10D 62/85, H10W 90/00

(54) **LEISTUNGSMODUL**

(30) Priorität: 28.11.2024 DE 102024135344
(71) Anmelder: Volkswagen Aktiengesellschaft, 38440 Wolfsburg (DE)
(72) Erfinder: Hartwig, Raphael, 38440 Wolfsburg (DE); Schiedermeier, Maximilian, 85139 Wettstetten (DE); Dr. Gaona, Daniel, 38440 Wolfsburg (DE)
(74) Vertreter: Zucker, Volker

(57) **Zusammenfassung**

Die Erfindung betrifft ein Leistungsmodul (1), wobei das Leistungsmodul (1) einen Träger (2) aufweist, wobei der Träger (2) eine Isolationsschicht (3) und eine strukturierte Metallisierung (4) auf einer Oberseite der Isolationsschicht (3) aufweist, wobei auf einer ersten Struktur der Metallisierung (4) mindestens ein planarer bidirektionaler GaN-Transistor (9) angeordnet ist, der ein Silizium-Substrat (12) aufweist, wobei der bidirektionale GaN-Transistor (9) einen ersten Anschluss (16) und einen zweiten Anschluss (17) sowie wie Gate-Anschlüsse (G1, G2) aufweist, wobei der erste Anschluss (16) mit einer zweiten Struktur (7) und der zweite Anschluss (17) mit einer dritten Struktur (8) der Metallisierung (4) elektrisch verbunden ist, wobei die erste, zweite und dritte Struktur (6-8) voneinander elektrisch isoliert sind, wobei zwischen der ersten Struktur (6) und der zweiten Struktur (7) und der ersten Struktur (6) und der dritten Struktur (8) mindestens ein Bauelement angeordnet ist, mittels dessen die erste Struktur (6) auf ein definiertes Potential festgelegt wird.

## Beschreibung

Die Erfindung betrifft ein Leistungsmodul mit mindestens einem planaren bidirektionalen GaN-Transistor.

Bidirektionale laterale GaN Halbleiter bieten für einige leistungselektronische Topologien große Vorteile. Eine Topologie, wo ein solcher bidirektionaler Schalter vorteilhaft eingesetzt werden kann, ist die 3-Level T-type Topologie. Die Topologie bietet auch für die Anwendung als Traktionswechselrichter viele Vorteile, da die Motorverluste stark reduziert werden können. Die High-Side-Schalter und Low-Side-Schalter haben im Vergleich zu einer 2-Level Topologie fast identische Anforderungen. Der mittlere Schalter muss allerdings eine Spannung in zwei Richtungen sperren können, weshalb dieser häufig mit Hilfe von zwei separaten Schaltern ausgeführt wird. Das Problem dabei ist, dass bei der Verwendung zweier MOSFETs auch bei gleicher Chipfläche die doppelten Durchlassverluste anfallen, weshalb man nochmals jeweils einen weiteren Schalter parallel schalten muss, um die gleichen Durchlassverluste zu erhalten. Aus diesem Grund benötigt man auch mit üblichen GaN-FETs die 4-fache Chipfläche, wenn man die Spannung in beide Richtungen sperren können möchte.

Derzeit gibt es starke Entwicklungsaktivitäten, um genau diesen negativen Effekt einer 4-fach größeren Chipfläche zu kompensieren. Dies soll mit bidirektionalen GaN-Schaltern möglich sein. Hierfür gibt es unterschiedliche Ansätze, wobei der Common-Drain-Ansatz derzeit der populärste und vielversprechendste Ansatz ist.

Eine Ausführungsform des Common-Drain ist in der US 8,604,512 B2 dargestellt. Der Vorteil dieses Ansatzes ist, dass die Drift-Zone (der Bereich, in dem sich der Großteil des zweidimensionalen Elektronengases (2DEG)) ausbildet, gemeinsam genutzt wird. Hierdurch lässt sich die Chipfläche verkleinern, da man in diesem Bereich den Spannungsabstand einhalten muss und dieser somit die Fläche stark beeinflusst. Diese Ansätze eines bidirektionalen lateralen GaN-Schalters haben allerdings alle das Problem, dass derzeit häufig aus Kostengründen ein Si-Substrat eingesetzt wird, welches nicht isolierend ist. Wird dieses Substrat nicht an ein Potential angebunden, können Effekte wie Threshold-Voltage-Verschiebungen oder dynamische Erhöhungen des R_{DSon} resultieren.

Aus diesem Grund wurde in der US 8,604,512 B2 und US 2014/0374766 A1 ein Ansatz beschrieben, wie das Substrat innerhalb des Halbleiters auf ein sinnvolles Spannungspotential gelegt werden kann. Sinnvolles Spannungspotential heißt hierbei, dass das Substrat immer auf das niedrigere anliegende Spannungspotential der beiden Anschlüsse S1/D2-, S2/D1 gelegt werden soll. Man versucht somit das gleiche Verhalten zu generieren, wie in einem normalen GaN-HEMT, in welchem das Substrat am Source angebunden ist. Hierfür können unterschiedliche Clamping-Schaltungen verwendet werden. Beispielsweise können zusätzliche monolithisch integrierte Schalter oder monolithisch integrierte Dioden/Widerstände verwendet werden, um das Substrat zu steuern.

Eine solche Lösung mit monolithisch integrierten Dioden ist beispielsweise aus der US 20220/416777 A1 bekannt.

Das Problem dieser Strategie ist, dass auf jedem Halbleiter zusätzliche Chipfläche für diese Substrat-Potentialsteuerung vorgesehen werden muss. Dies hat einen negativen Einfluss auf die Chipfläche.

Zudem wird diese Schaltung bei parallel geschalteten Schaltern für jeden Schalter benötigt und diese können sich negativ beeinflussen, wenn die Substrate miteinander verbunden sind. Dies ist beispielsweise der Fall, wenn der Schalter mit seinem Substrat auf einen Träger mit einer Metallisierung aufgebracht wird. Ein solcher Träger kann beispielsweise ein DCB- oder IMS-Träger sein.

Zudem kann bei einem solchen Aufbau aufgrund der schlechten Leitfähigkeit des Substrates keine Schottky Diode zwischen dem Substrat und den S/D- bzw. D/S-Anschlüssen eingesetzt werden, um die Verluste während der Leitung im dritten Quadranten im ausgeschalteten Zustand zu reduzieren. Dies ist besonders für hart schaltende Anwendungen mit einer hohen Schaltfrequenz sehr relevant (Schalter werden lediglich während der Einschaltverzögerung des Delays in diesem Bereich betrieben, aber aufgrund des hohen Spannungsabfalls der GaN-FETs in diesem Bereich sind die Verluste bei hohen Schaltfrequenzen dennoch relevant).

Der Erfindung liegt das technische Problem zugrunde, ein Leistungsmodul mit mindestens einem planaren bidirektionalen GaN-Transistor zu schaffen, bei dem die zuvor beschriebenen Probleme reduziert sind.

Die Lösung des technischen Problems ergibt sich durch ein Leistungsmodul mit den Merkmalen des Anspruchs 1. Weitere vorteilhafte Ausgestaltungen der Erfindung ergeben sich aus den Unteransprüchen.

Das Leistungsmodul weist einen Träger auf, wobei der Träger eine Isolationsschicht und eine strukturierte Metallisierung auf der Oberseite der Isolationsschicht aufweist. Die Isolationsschicht ist beispielsweise eine Keramik. Der Träger kann beispielsweise ein DCB- oder IMS-Träger sein. Dabei ist mindestens ein planarer bidirektionaler GaN-Transistor auf einer ersten Struktur der Metallisierung angeordnet. Der GaN-Transistor weist ein Silizium-Substrat auf. Weiter weist der bidirektionale GaN-Transistor einen ersten Anschluss und einen zweiten Anschluss sowie zwei Gate-Anschlüsse auf. Der erste Anschluss und der zweite Anschluss sind dabei je nach Stromrichtung einmal der Source-Anschluss und einmal der Drain-Anschluss und umgekehrt. Der erste Anschluss ist mit einer zweiten Struktur und der zweite Anschluss ist mit einer dritten Struktur der Metallisierung elektrisch verbunden. Die elektrische Verbindung kann beispielsweise mittels Bonddrähten erfolgen. Dabei sind die erste, zweite und dritte Struktur elektrisch isoliert, wobei zwischen der ersten Struktur und der zweiten Struktur und der ersten Struktur und der dritten Struktur mindestens ein Bauelement angeordnet ist, mittels dessen die erste Struktur auf ein definiertes Potential festgelegt wird. Hierdurch wird auch das Silizium-Substrat auf ein definiertes Potential gelegt. Anschaulich wird die Substrat-Potentialsteuerung aus dem GaN-Transistor herausgenommen und durch eine externe Substrat-Potentialsteuerung ersetzt, sodass der GaN-Transistor keine Chipfläche verliert. Ein weiterer Vorteil ist, dass die Verlustwärme der Bauelemente keinen unmittelbaren Einfluss auf den GaN-Transistor hat.

In einer Ausführungsform weist das Leistungsmodul zwei parallel geschaltete bidirektionale GaN-Transistoren auf, deren Silizium-Substrate elektrisch verbunden sind. Dabei muss die externe Substrat-Potentialsteuerung nur einfach ausgebildet sein.

In einer Ausführungsform ist auf der ersten Struktur ein erster Transistor und ein zweiter Transistor angeordnet, wobei der erste Transistor mit der zweiten Struktur und der zweite Transistor mit der dritten Struktur verbunden ist. Vorzugsweise ist das Leistungsmodul derart ausgebildet, dass der erste Transistor durchgeschaltet wird, wenn das Spannungspotential am ersten Anschluss niedriger ist als am zweiten Anschluss, und der zweite Transistor durchgeschaltet wird, wenn das Spannungspotential am ersten Anschluss höher ist als am zweiten Anschluss.

In einer weiteren Ausführungsform ist eine Treiberschaltung des ersten und zweiten Transistors monolithisch in die Transistoren integriert, sodass die Schaltung recht kompakt ist.

In einer weiteren Ausführungsform sind der erste Transistor und der zweite Transistor als GaN-Transistoren ausgebildet.

In einer weiteren Ausführungsform ist parallel zum ersten Transistor und parallel zum zweiten Transistor jeweils eine Schottky-Diode angeordnet.

In einer alternativen Ausführungsform sind die Bauelemente nicht als Transistoren, sondern als Parallelschaltung eines Widerstandes und einer Diode, vorzugsweise einer Schottky-Diode, ausgebildet. Der Vorteil ist, dass es keiner aktiven Steuerung bedarf, wobei aufgrund des Widerstandes die Potentiale der ersten und zweiten bzw. der ersten und dritten Struktur nicht vollständig gleich sind.

In einer weiteren Ausführungsform ist an der Unterseite der Isolationsschicht eine weitere Metallisierung aufgebracht, mittels der das Leistungsmodul beispielsweise an einem Kühlkörper angebunden werden kann.

Die Erfindung wird nachfolgend anhand bevorzugter Ausführungsformen näher erläutert. Die Figuren zeigen:
- Fig. 1: eine schematische Darstellung eines Leistungsmoduls in einer ersten Ausführungsform,
- Fig. 2: eine schematische Darstellung eines Leistungsmoduls in einer zweiten Ausführungsform und
- Fig. 3: eine schematische Darstellung eines 3-L-T-Type-Wechselrichters (Stand der Technik).

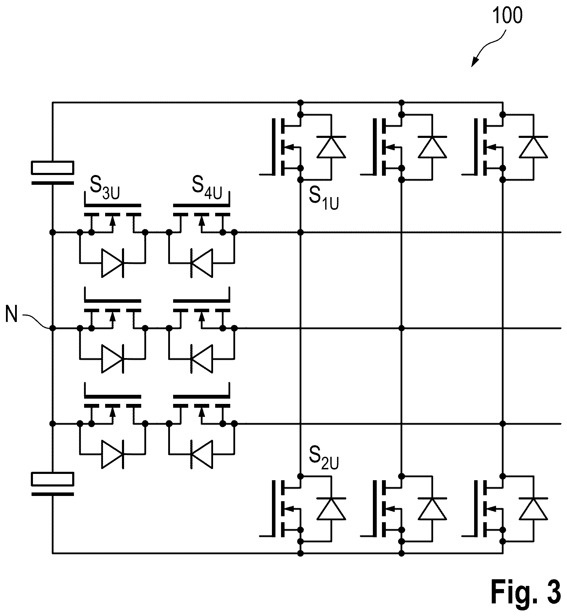

In der Fig. 3 ist ein 3-Level-T-Type-Wechselrichter 100 dargestellt, der drei High-Side-Schalter S_{1U} und drei Low-Side-Schalter S_{2U} aufweist. Zwischen einem Neutralpunkt N und den Mittelabgriffen zwischen High-Side-Schalter S_{1U} und Low-Side-Schalter S_{2U} sind jeweils zwei gegensinnig zueinander verschaltete MOSFETs S_{3U}, S_{4U} angeordnet. Diese mittleren MOSFETs S_{3U}, S_{4U} sollen nun durch mindestens einen bidirektionalen planaren GaN-Transistor ersetzt werden.

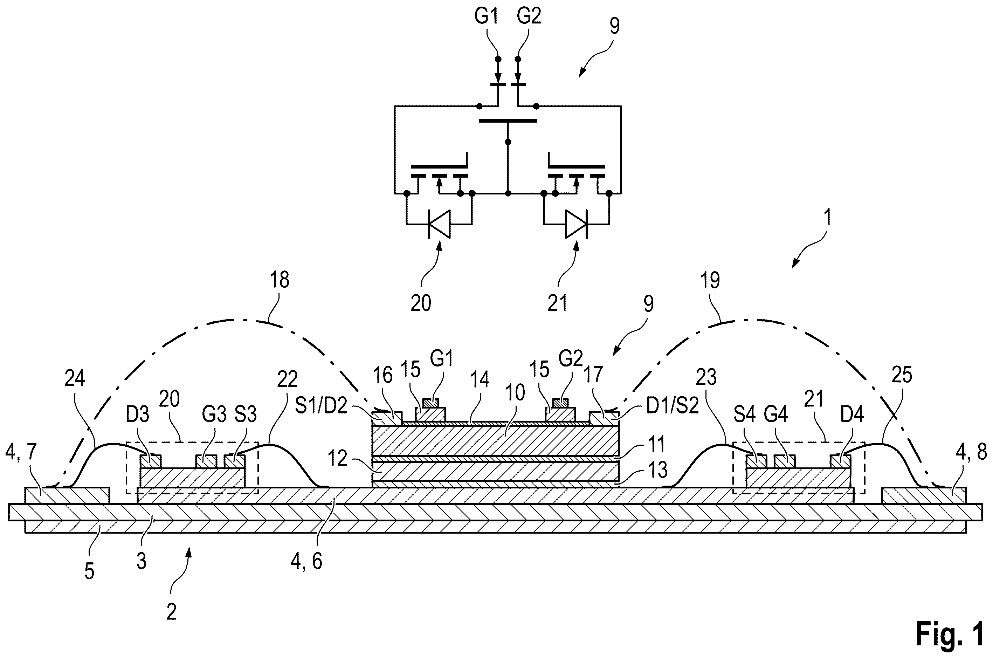

In der Fig. 1 ist ein Leistungsmodul 1 dargestellt, das einen Träger 2 aufweist, der eine Isolationsschicht 3 und eine strukturierte Metallisierung 4 auf der Oberseite und eine weitere Metallisierung 5 auf der Unterseite aufweist. Die strukturierte Metallisierung 4 weist eine erste Struktur 6, eine zweite Struktur 7 und eine dritte Struktur 8 auf. Die strukturierte Metallisierung 4 kann dabei noch weitere Strukturen aufweisen. Auf der ersten Struktur 6 ist ein planarer bidirektionaler GaN-Transistor 9 angeordnet. Der bidirektionale GaN-Transistor 9 weist eine GaN-Schicht 10, eine Bufferschicht 11 und ein Silizium-Substrat 12 auf, wobei das Silizium-Substrat 12 über eine Verbindungsschicht 13 (z.B. als Löt- oder Sinterschicht) elektrisch mit der ersten Struktur 6 verbunden ist. Auf der GaN-Schicht 10 ist eine AlGaN-Schicht aufgebracht, auf der zwei P-GaN-Schichten 15 nebeneinander angeordnet sind, auf denen eine Metallisierung ist. Dies bildet einen ersten Gate-Kontakt G1 und einen zweiten Gate-Kontakt G2 aus. Weiter weist der GaN-Transistor 9 einen ersten Anschluss 16 und einen zweiten Anschluss 17 auf, die je nach Stromrichtung mal als Source- und mal als Drainkontakt arbeiten. Der erste Anschluss 16 ist beispielsweise über einen Bonddraht 18 mit der zweiten Struktur 7 und der zweite Anschluss 17 ist beispielsweise über einen Bonddraht 19 mit der dritten Struktur 8 verbunden. Weiter ist auf der ersten Struktur 6 ein erster Transistor 20 und ein zweiter Transistor 21 angeordnet, die beispielsweise als MOSFETs mit intrinsischer Diode ausgebildet sind. Dabei ist der Source-Anschluss S3 des ersten Transistors 20 über einen Bonddraht 22 mit der ersten Struktur 6 verbunden. Entsprechend ist der Source-Anschluss S4 des zweiten Transistors 21 über einen Bonddraht 23 mit der ersten Struktur 6 verbunden. Der Drain-Anschluss D3 des ersten Transistors 20 ist über einen Bonddraht 24 mit der zweiten Struktur 7 und der Drain-Anschluss D4 des zweiten Transistors 21 ist über einen Bonddraht 25 mit der dritten Struktur 8 verbunden.

Je nach Stromrichtung des GaN-Transistors 9 wird der Transistor 20, 21 durchgeschaltet, der dem jeweiligen Source-Kontakt zugeordnet ist, d.h. arbeitet der erste Anschluss 16 als Source-Kontakt S1, so wird der erste Transistor 20 durchgeschaltet, sodass der Source-Kontakt S1 über die zweite Struktur 7 und den ersten Transistor 20 mit der ersten Struktur 6 sowie darüber mit dem Silizium-Substrat 12 verbunden ist. Entsprechend wird der erste Transistor 20 gesperrt und der zweite Transistor 21 durchgeschaltet, wenn der zweite Anschluss 17 als Source-Kontakt S2 arbeitet. Somit ist das Silizium-Substrat 12 immer mit dem niedrigsten Potential des GaN-Transistors 9 verbunden. In der Fig. 1 ist oben das zugehörige Ersatzschaltbild dargestellt.

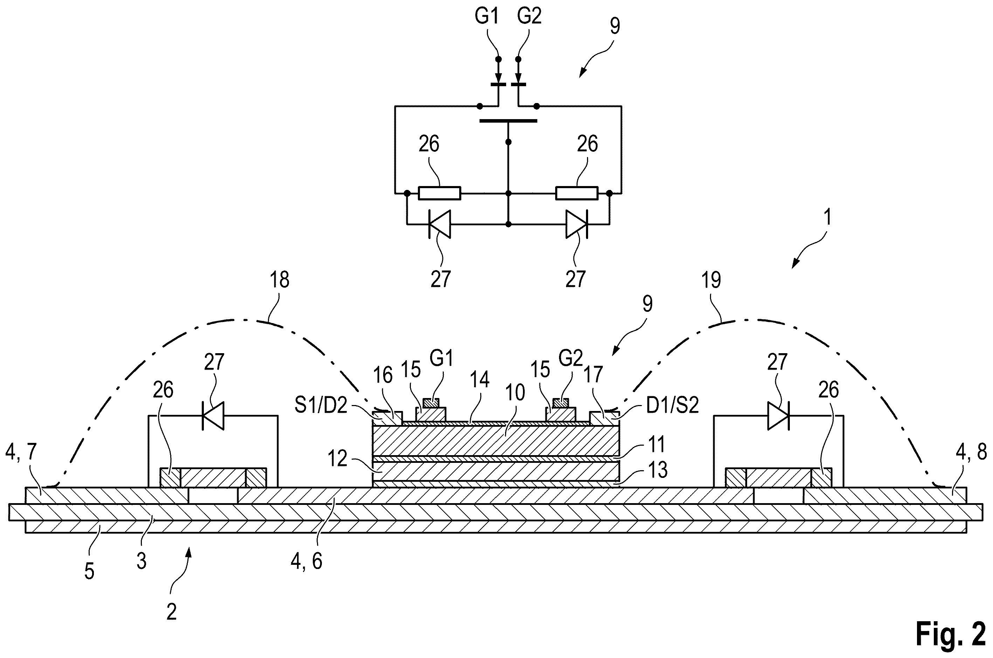

In der Fig. 2 ist eine alternative Ausführungsform eines Leistungsmoduls 1 dargestellt. Der einzige Unterschied ist, dass die Transistoren 20, 21 aus Fig. 1 durch eine Parallelschaltung aus einem Widerstand 26 und einer Diode 27 ersetzt sind. Hier findet keine aktive Substrat-Steuerung statt, aber über die Widerstände 26 ist das Substrat-Potential festgelegt und kann nicht mehr floaten.

### Bezugszeichenliste

- 1: Leistungsmodul
- 2: Träger
- 3: Isolationsschicht
- 4: strukturierte Metallisierung
- 5: weitere Metallisierung
- 6: erste Struktur
- 7: zweite Struktur
- 8: dritte Struktur
- 9: GaN-Transistor
- 10: GaN-Schicht
- 11: Bufferschicht
- 12: Silizium-Substrat
- 13: Verbindungsschicht
- 14: AlGaN-Schicht
- 15: R-GaN-Schicht
- 16: erster Anschluss
- 17: zweiter Anschluss
- 18: Bonddraht
- 19: Bonddraht
- 20: erster Transistor
- 21: zweiter Transistor
- 22: Bonddraht
- 23: Bonddraht
- 24: Bonddraht
- 25: Bonddraht
- 26: Widerstand
- 27: Diode
- 100: 3-Level-T-Type-Wechselrichter
- G1: erster Gate-Kontakt
- G2: zweiter Gate-Kontakt
- N: Neutralpunkt
- S1: Source-Kontakt
- S2: Source-Kontakt
- S_{1U}: High-Side-Schalter
- S_{2U}: Low-Side-Schalter
- S_{3U}, S_{4U}: MOSFETs

## Patentansprüche

1. Leistungsmodul (1), wobei das Leistungsmodul (1) einen Träger (2) aufweist, wobei der Träger (2) eine Isolationsschicht (3) und eine strukturierte Metallisierung (4) auf einer Oberseite der Isolationsschicht (3) aufweist, wobei auf einer ersten Struktur der Metallisierung (4) mindestens ein planarer bidirektionaler GaN-Transistor (9) angeordnet ist, der ein Silizium-Substrat (12) aufweist, wobei der bidirektionale GaN-Transistor (9) einen ersten Anschluss (16) und einen zweiten Anschluss (17) sowie wie Gate-Anschlüsse (G1, G2) aufweist, wobei der erste Anschluss (16) mit einer zweiten Struktur (7) und der zweite Anschluss (17) mit einer dritten Struktur (8) der Metallisierung (4) elektrisch verbunden ist, wobei die erste, zweite und dritte Struktur (6-8) voneinander elektrisch isoliert sind, wobei zwischen der ersten Struktur (6) und der zweiten Struktur (7) und der ersten Struktur (6) und der dritten Struktur (8) mindestens ein Bauelement angeordnet ist, mittels dessen die erste Struktur (6) auf ein definiertes Potential festgelegt wird.

2. Leistungsmodul (1) nach Anspruch 1, **dadurch gekennzeichnet, dass** das Leistungsmodul mindestens zwei parallel geschaltete bidirektionale GaN-Transistoren (9) aufweist, deren Silizium-Substrate (12) elektrisch verbunden sind.

3. Leistungsmodul (1) nach Anspruch 1 oder 2. **Dadurch gekennzeichnet, dass** auf der ersten Struktur (6) ein erster Transistor (20) und ein zweiter Transistor (21) angeordnet ist, wobei der erste Transistor (20) mit der zweiten Struktur (7) und der zweite Transistor (21) mit der dritten Struktur (8) verbunden ist.

4. Leistungsmodul (1) nach Anspruch 3, **dadurch gekennzeichnet, dass** das Leistungsmodul (1) derart ausgebildet ist, dass der erste Transistor (20) durchgeschaltet wird, wenn das Spannungspotential am ersten Anschluss (16) niedriger ist als am zweiten Anschluss (17) und der zweiter Transistor (21) durchgeschaltet wird, wenn das Spannungspotential am ersten Anschluss (16) höher ist als am zweiten Anschluss (17).

5. Leistungsmodul (1) nach Anspruch 3 oder 4, **dadurch gekennzeichnet, dass** eine Treiberschaltung des ersten und zweiten Transistors (20, 21) monolithisch in die Transistoren (20, 21) integriert ist.

6. Leistungsmodul (1) nach einem der Ansprüche 3 bis 5, **dadurch gekennzeichnet, dass** der erste Transistor und der zweite Transistor als GaN-Transistor ausgebildet ist.

7. Leistungsmodul (1) nach einem der Ansprüche 3 bis 6, **dadurch gekennzeichnet, dass** parallel zum ersten Transistor (20) und parallel zum zweiten Transistor (21) jeweils eine Schottky-Diode angeordnet ist.

8. Leistungsmodul (1) nach Anspruch 1 oder 2, **dadurch gekennzeichnet, dass** die Bauelemente als Parallelschaltung eines Widerstandes (26) und einer Diode (27) ausgebildet sind.

9. Leistungsmodul (1) nach einem der vorangegangenen Ansprüche, **dadurch gekennzeichnet, dass** an der Unterseite der Isolationsschicht (3) eine weitere Metallisierung (5) aufgebracht ist.
